# EUROPÄISCHE PATENTANMELDUNG

(11) **EP 2 482 339 A1**
(43) Veröffentlichungstag der Anmeldung: **01.08.2012**
(21) Anmeldenummer: 12152408.6
(22) Anmeldetag: 25.01.2012
(51) Int. Cl.: H01L 31/048

(54) **Anschlussdosengehäuse für Photovoltaikanschlussdosen**

(30) Priorität: 26.01.2011 CH 1292011
(71) Anmelder: Multi-Holding AG, 4123 Allschwil (CH)
(72) Erfinder: Torma, Andreas, 46284 Dorsten (DE)
(74) Vertreter: Frischknecht, Harry Ralph

(57) **Zusammenfassung**

Ein Anschlussdosengehäuse (1) für eine Photovoltaikpaneele (2) umfasst eine Seitenwandung (3), einen eine Bodenebene (7) aufspannenden Boden (4) und einen Deckel (5) umfassen, wobei Seitenwandung (3), Boden (4) und Deckel (5) einen Innenraum (6) zur Aufnahme von Funktionselementen - zur Wegführung von durch die Photovoltaikpaneele (2) erzeugter elektrischer Energie begrenzen. Das Anschlussdosengehäuse (1) ist mit dem Boden (4) auf einer Photovoltaikpaneele (2) anordbar. Das Anschlussdosengehäuse (1) steht weiterhin mit mindestens einem Distanzelement (8) in Verbindung, das derart angeordnet ist, dass eine Kraft, welche von einem auf der mit dem Anschlussdosengehäuse (1) versehenen Photovoltaikpaneele (2) liegenden Photovoltaikmodul (P) bereitgestellt wird, vorzugsweise ausschliesslich über das Distanzelement (8) auf die Photovoltaikpaneele (2) mit dem Anschlussdosengehäuse (1) geleitet wird.

## Beschreibung

### TECHNISCHES GEBIET

Die vorliegende Erfindung betrifft ein Anschlussdosengehäuse für eine PhotovoltaikAnschlussdose nach dem Oberbegriff von Anspruch 1.

### STAND DER TECHNIK

Aus dem Stand der Technik sind Anschlussdosen für Photovoltaikmodule bekannt. Solche Anschlussdosen dienen der Aufnahme einer Bypass-Diode, so dass bei teilweise abgeschalteter Solarzelle bzw. Photovoltaikpaneelen die damit verbundenen Problematiken verhindert werden können.

Beispielsweise zeigt die WO 2009/062326 eine derartige Anschlussdose. Solche Anschlussdosen werden typischerweise mit einem Klebstoff mit der Oberfläche der Solarpaneele verbunden. Dieser Klebstoff muss gewissen Anforderungen bezüglich Langlebigkeit, Temperaturschwankungen, und auch bezüglich mechanischen Einflüssen, beispielsweise gegen Scherkräfte etc., entsprechen.

Beim Einbau einer Solaranlage werden meist eine Vielzahl von bereits vorfabrizierten Solarpaneelen gemeinsam eingebaut. Typischerweise werden die Photovoltaikpaneelen werkseitig soweit fertig gestellt, dass beim Einbau nur noch die mechanische Verankerung und die elektrische Verschaltung vorgenommen werden muss. Insbesondere ist es so, dass die Anschlussdosen bereits mit der Photovoltaikpaneele fest verbunden ist.

Vielfach treffen die Spediteure, welche die Photovoltaikpaneelen anliefern, bei den Baustellen auf sehr enge Platzverhältnisse, wobei diese dann die Photovoltaikpaneelen aufeinander stapeln. Meist liegen dann mehrere Photovoltaikpaneelen aufeinander und werden über die Anschlussdosen zueinander abgestützt. Dies kann dazu führen, dass der Klebstoff zwischen Anschlussdose und Photovoltaikpaneele zu fliessen beginnt, und entlang der Oberfläche der Photovoltaikpaneele aus dem Bereich der Verbindung zwischen Anschlussdose und Photovoltaikpaneele herausfliesst. Dies ist nachteilig bezüglich der Dauerhaftigkeit der Verbindung zwischen Anschlussdose und Photovoltaikpaneele. Der gleiche negative Effekt kann auch beim Stapeln der Photovoltaikpaneelen an einer Wand auftreten.

### DARSTELLUNG DER ERFINDUNG

Ausgehend von diesem Stand der Technik liegt der Erfindung eine Aufgabe zugrunde, eine Anschlussdose für Photovoltaikpaneelen anzugeben, welche die Nachteile des Standes der Technik überwindet. Insbesondere soll die Anschlussdose verbesserte Eigenschaften bei Transport und Lagerung aufweisen.

Eine solche Aufgabe löst ein Anschlussdosengehäuse nach Anspruch 1. Demgemäss umfasst ein Anschlussdosengehäuse für eine Photovoltaikpaneele eine Seitenwandung, einen eine Bodenebene aufspannenden Boden und einen Deckel, wobei Seitenwandung, Boden und Deckel einen Innenraum zur Aufnahme von Funktionselementen zur Wegführung von durch die Photovoltaikpaneele erzeugter elektrischer Energie begrenzen. Das Anschlussdosengehäuse ist mit dem Boden auf einer Photovoltaikpaneele anordbar. Bevorzugterweise wird das Anschlussdosengehäuse über eine Klebeverbindung mit der Photovoltaikpaneele verbunden. Das Anschlussdosengehäuse steht weiterhin mit mindestens einem Distanzelement in Verbindung, das derart angeordnet ist, dass eine Kraft, welche von einem auf der mit dem Anschlussdosengehäuse versehenen Photovoltaikpaneele liegenden Photovoltaikmodul bereitgestellt wird bzw. herrührt, vorzugsweise ausschliesslich über das Distanzelement auf die Photovoltaikpaneele mit dem Anschlussdosengehäuse geleitet wird. Besonders bevorzugt wird die Kraft ausschliesslich über die Distanzelemente übertragen.

Folglich wird das Anschlussdosengehäuse als solches, also die Seitenwandung, der Boden und der Deckel, bei der Lagerung und beim Transport von den Gewichtskräften der anderen Photovoltaikmödulen mindestens teilweise entlastet. Bei einer Klebeverbindung wird zudem der Klebstoff entlastet, was ein seitliches Fliessen verhindert. Das Distanzelement könnte man daher auch als Stäpelelement bezeichnen.

Besonders bevorzugt liegt das benachbarte Photovoltaikmodul vollständig bzw. ausschliesslich auf dem Distanzelement auf.

Vorzugsweise ist das Distanzelement in einer Ausgangsstellung bezüglich der Senkrechten zur Bodenebene von der Bodenebene beabstandet angeordnet und bei einer Krafteinwirkung, insbesondere durch das Photovoltaikmodul von der Ausgangsstellung in eine Endstellung zur Bodenebene bewegbar. Die beabstandete Anordnung hat den Vorteil, dass bei einem ansteigen der Kraft, der Zwischenraum stetig kleiner wird, bis das Distanzelement auf der Oberfläche des Photovoltaikpaneele aufliegt. Durch diese Bewegbarkeit kann zudem eine unterschiedliche Dicke des Klebstoffes ausgeglichen werden.

Vorzugsweise weist das Distanzelement bezüglich der Senkrechten zur Bodenebene eine Höhe auf, welche grösser ist, als die Distanz zwischen dem Boden und dem Deckel bezüglich der Senkrechten zur Bodenebene. Insbesondere ist die Höhe grösser als die Distanz zwischen der Oberfläche der Photovoltaikpaneele und dem Deckel des Anschlussdosengehäuses.

Vorzugsweise ist Distanzelement über eine federnd ausgebildete Kontaktlasche am Anschlussdosengehäuse angeformt, wobei bei einer Krafteinwirkung auf das Distanzelement die Kontaktlasche federnd verformbar ist.

Vorzugsweise weist die Kontaktlasche im Querschnitt senkrecht zur Bodenebene gesehen zwischen Seitenwandung und Distanzelement eine Querschnittsverjüngung auf und/oder die Kontaktlasche ist als Filmscharnier ausgebildet. Dadurch können die federnden Eigenschaften stark verbessert werden.

Vorzugsweise erstreckt sich die Kontaktlasche im wesentlichen parallel zur Bodenebene, und/oder das Distanzelement erstreckt sich im wesentlichen senkrecht von der Kontaktlasche bzw. senkrecht zur Bodenebene.

Vorzugsweise ist das mindestens eine Distanzelement und das Anschlussdosengehäuse einstückig ausgebildet.

Eine Photovoltaikanschlussdose umfasst ein Anschlussdosengehäuse gemäss obiger Beschreibung und Funktionselemente, die im Innenraum des Anschlussdosengehäuses angeordnet sind. Die Funktionselemente zur dienen zur Wegführung von durch die Photovoltaikpaneele erzeugter elektrischer Energie, wobei die Funktioriselemente vorzugsweise Verbindungselemente, eine Bypass-Diode und Anschlusselemente umfassen, wobei die Verbindungselemente der elektrisch leitenden Verbindung mit der Photovoltaikpaneele und der Bypassdiode dienen und wobei die Anschlusselemente der elektrisch leitenden Verbindung der Bypassdiode und externen Elementen, wie Kabel dienen.

Ein Photovoltaikmodul umfasst eine Photovoltaikpaneele und mindestens eine Anschlussdose mit einem Anschlussdosengehäuse gemäss obiger Beschreibung.

Weitere Ausführungsformen sind in den abhängigen Ansprüchen angegeben.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränken auszulegen sind. In den Zeichnungen zeigen:
- Fig. 1: eine perspektivische Ansicht einer Anschlussdose für eine Photovoltaikpaneele von oben;
- Fig. 2: eine perspektivische Ansicht der Anschlussdose nach Figur 1 von unten;
- Fig. 3: eine Seitenansicht von drei übereinander gestapelten Photovoltaikmodulen mit einer Photovoltaikpaneele und einer Anschlussdosen nach Figur 1;
- Fig. 4: eine Detailansicht eines an der Anschlussdose nach Figur 1 angeformten Distanzhalters.

### BESCHREIBUNG BEVORZUGTER AUSFÜHRUNGSFORMEN

Photovoltaik-Anschlussdosem oder PV-Anschlussdosen stehen in Kontakt mit den Photövöltaikpaneelen und dienen zur Wegführung von elektrischer Energie, die durch die Photovoltaikpaneelen bereitgestellt wird bzw. zur Verbindung von mehreren Photovoltaikmodulen untereinander. Derartige Anschlussdosen umfassen typischerweise ein Anschlussdosengehäuse 1 sowie diverse den elektrischen Strom leitende Funktionselemente.

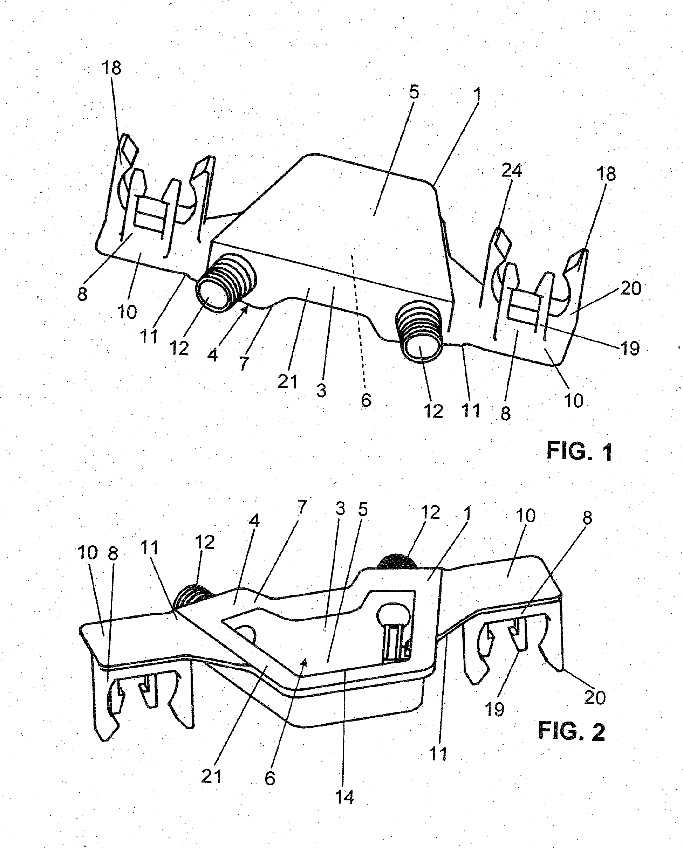

In den Figuren 1 und 2 wird ein Anschlussdosengehäuse 1 für eine Photovoltaikpaneele 2 gezeigt. Das Anschlussdosengehäuse 1 dient im Wesentlichen der Aufnahme der elektrisch leitenden Funktionseleinenten, wie beispielsweise einer Bypassdiode, extern zugänglichen Anschlusselementen, wie Steckerelemente und Buchsenelemente, zur Verbindung mit externen Kabeln, sowie Verbindungselemente zur Verbindung der Diode und der extern zugänglichen Anschlusselementen mit der Photovoltaikpaneelen. Das Anschlussdosengehäuse 1 wird auf eine Photovoltaikpaneele aufgeklebt und über die Verbindungselemente mit den elektrisch leitenden Elementen der Photovoltaikpaneele elektrisch leitend verbunden, wobei so ein Photovoltaikmodul geschaffen wird. Unter der Ausdrucksweise Photovoltaikmodul wird demnach die Kombination von Anschlussdose und Photovoltaikpaneele, also ein einsatzbereites Photovoltaikmodul verstanden. Über die Anschlussdose können mehrere Photovoltaikmodule miteinander verbunden werden.

Das in den Figuren 1 und 2 gezeigt Anschlussdosengehäuse 1 umfasst eine Seitenwandung 3, einen Boden 4 und einen Deckel 5. Seitenwandung 3, Boden 4 und Deckel 5 begrenzen einen Innenraum 6, welcher der Aufnahme der Bypassdiode, sowie der anderen Funktionselementen dient. Der Innenraum 6 ist über eine Öffnung 14 zugänglich, wobei hier die Öffnung 14 im Bereich des Bodens 4 angeordnet ist. Durch diese Öffnung 14 kann ein elektrischer Kontakt zwischen den elektrisch leitenden Funktionselementen im Innenraum 6 und denjenigen der Photovoltaikpaneele2 bereitgestellt werden. Zusätzlich könnte auch im Deckel 5 eine Öffnung angeordnet sein, über welche die besagten elektrisch leitenden Elemente mit denjenigen der Photovoltaikpaneele verbunden werden können. Diese Öffnung könnte dann durch einen separat ausgebildeten Deckel verschlossen werden.

Der Boden 4 spannt eine Ebene auf, welche als Bodenebene 7 bezeichnet wird. Wenn das Anschlussdosengehäuse 1 auf der Photovoltaikpaneele 2 angeordnet ist, verläuft die Bodenebene 7 im Wesentlichen parallel zur Oberfläche 16 der Photovoltaikpaneele 2. Die Anschlussdose wird mittels einem Klebstoff, einer Silikonraupe oder einem Klebepad 15 auf die Oberfläche 16 aufgeklebt, wobei sich der Klebstoff 15 vorzugsweise über die gesamte Oberfläche des Bodens 4 erstreckt.

Der Boden 4 ist in der vorliegenden Ausführungsform als Flansch 21 angeordnet. Der Flansch 21 verläuft im Wesentlichen senkrecht zur Seitenwandung 3. Von der Seitenwandung 3 erstreckt sich der Flansch 21 bezüglich des Innenraums 6 nach aussen beziehungsweise teilweise nach innen zum Innenraum 6 hin. Der Flansch 21 umgibt die Seitenwandung 3 mindestens abschnittsweise, vorzugsweise aber vollständig, wobei ein umlaufender Flansch 21 bereitgestellt wird.

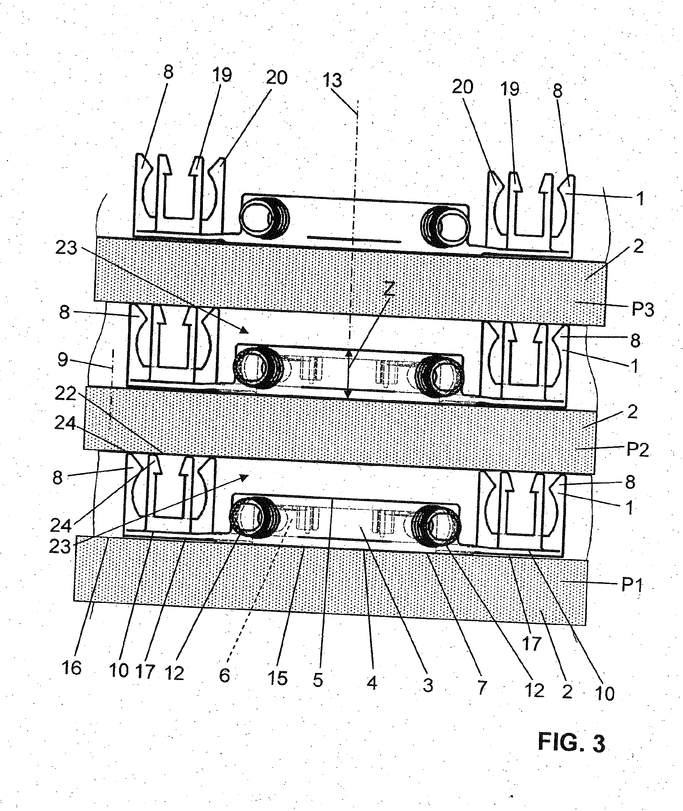

Das Anschlussdosengehäuse 1 umfasst weiterhin mindestens ein Distanzelement 8. Das Distanzelement 8 dient im Wesentlichen der Kraftübertragung, wenn die Photovoltaikmodule aufeinander gestapelt werden bzw. aneinander anlehnen. Dies wird in der Figur 3 gezeigt, wobei hier drei Photovoltaikmodule P1, P2 und P3 übereinander angeordnet sind. Das unterste Photovoltaikmodul P 1 trägt dabei das Gewicht der auf dem untersten Photovoltaikmodul P1 aufliegenden Photovoltaikmodule P2 und P3 und das mittlere Photovoltäikmodul trägt hier das Gewicht des obersten Photovoltaikmoduls P3. Das Gewicht wirkt dabei als Gewichtskraft auf das unterste und das mittlere Photovoltaikmodul. Wenn die Photovoltaikmodule P1, P2, P3 an einer Wand anlehnen, so wird eine Kraftkompomente der Gewichtskraft über den gestapelten Photovoltaikmodule übertragen. Nachfolgend wir der Einfachheit halber von Kraft gesprochen, wobei als Kraft die Einwirkung des Gewichtes auf ein erstes Photovoltaikmodul durch ein oder mehrere auf dem ersten Photovoltaikmodul aufliegendem zweiten Photovoltaikmodul verstanden wird. Diese Kraft wird durch die Distanzelemente 8 von den zwei benachbarten Photovoltaikmodulen P1, P2, bzw. P2, P3 auf das jeweilige andere Photovoltaikmodul übertragen. Durch die Anordnung des mindestens einen Distanzelementes 8 wird eine gute Übertragung der Gewichtskraft erreicht.

Das mindestens eine Distanzelement 8 ist dabei derart angeordnet, dass die Kraft vorzugsweise ausschliesslich über das Distanzelement' 8 auf die Photovoltaikpaneelen geleitet wird. Folglich wirkt keine oder eine stark verringerte Kraft über den Boden 4 des Anschlussdosengehäuse 1 ein. Dadurch wird die Klebestelle 15 zwischen Boden 4 und Oberfläche 16 der Photovoltaikpaneele 2 erheblich oder gar ganz entlastet; was ein seitliches Fliessen des Klebstoffes 15 verhindert. Zusammenfassend kann gesagt werden, dass das Distanzelement 8 die Anschlussdose und die Klebestelle 15 vor einer Kräfteeinwirkung schützt.

Mit anderen Worten kann gesagt werden, dass durch diese Art der Kraftübertragung zwischen zwei benachbarten bzw. übereinander liegenden Photovoltaikmodulen dabei sicher gestellt werden kann, dass keine direkte Kraft auf das Anschlussdosengehäuse 1 als solches, also auf Seitenwandung 3, Boden 4 und Deckel 5 übertragen wird bzw. die Krafteinwirkung auf das Anschlussdosengehäuse 1 limitiert werden kann. Somit wird die Verbindungsstelle zwischen Boden 4 und Oberfläche 16 der Photovoltaikpaneele 2 entlastet.

Das Distanzelement 8 ist vorzugsweise bezüglich des Bodens 4 des Anschlussdosengehäuse 1 bzw. der Oberfläche 16 der Photovoltaikpaneele 2 bewegbar ausgebildet. Demnach ist das Distanzelement 8 von einer Ausgangsstellung in eine Endstellung bezüglich einer Senkrechten 9 zur Bodenebene 7 bzw. zur Oberfläche 16 hin bewegbar.

In der Ausgangsstellung ist das Distanzelement 8 von der Bodenebene 7 beabstandet angeordnet. Wenn das Anschlussdosengehäuse 1 mit der Photovoltaikpaneele 2 in Verbindung steht, also im eingebauten Zustand, ist zwischen dem Distanzelement 8 und der Oberfläche der Photovoltaikpaneele 2 ein Zwischenraum 17 vorhanden. Bei einer Krafteinwirkung, insbesondere durch das Photovoltaikmodul P2, P3, welches auf dem Distanzelement 8 aufliegt, wird das Distanzelement 8 von der Ausgangsstellung in eine Endstellung zur Bodenebene 7 bzw. zur Oberfläche 16 des Photovoltaikmodul 2 bewegt. In der Endstellung liegt dann das Distanzelement 8 vollständig auf der Oberfläche 16 des Photovoltaikmoduls 2 auf und stützt dabei das darüber angeordnete Photovoltaikmodul gegen die Photovoltaikpaneele 2 ab.

Das Distanzelement 8 weist bezüglich der Senkrechten 9 zur Bodenebene 7 eine Höhe H auf. Diese Höhe H ist vorzugsweise grösser gewählt als die Distanz Z zwischen der Oberfläche 16 der Photovoltaikpaneele 2 bzw. dem Boden 4 und dem Deckel 5, wobei die Distanz Z ebenfalls in der Senkrechten 9 zur Bodenebene 7 definiert wird. Dadurch kann sichergestellt werden, dass das Photovoltaikmodul nicht mit dem Deckel 5 des Anschlussdosengehäuses 1 in Verbindung kommt, wobei somit sichergestellt wird, dass über die Seitenwandung 3 und den Boden 4 keine Kraft übertragen wird, was zur oben beschriebenen Entlastung der Klebestelle 15 führt.

Folglich steht die Unterseite 22 des Photovoltaikmoduls P2, welches am Photovoltaikmodul P1 mit dem Anschlussdosengehäuse 1 aufliegt, nicht mit dem Anschlussdosengehäuse 1 sondern mit dem Distanzelement 8 in Verbindung. Zwischen Unterseite 22 und dem Deckel 5 des Anschlussdosengehäuses 1 ist folglich ein Zwischenraum 23 vorhanden. Mit anderen Worten kann auch gesagt werden, dass die Unterseite 22 auf einer Stirnfläche 24 des Distanzelementes 8 aufliegt.

Besonders bevorzugt steht das Distanzelement 8 über eine federnd ausgebildete Kontaktlasche 10 mit dem Boden 4 und/oder der Seitenwandung 3 und/oder dem Deckel 5 in Verbindung. In der vorliegenden Ausführungsform erstreckt sich die Seitenwandung 3 vom Übergangsbereich zwischen Seitenwandung 3 und Boden 4 oder vom Flansch 21 weg. Es kann auch gesagt werden, dass die Kontaktlasche 10 am Anschlussdosengehäuse 1 angeformt ist. Unter der Ausdrucksweise federnd wird verstanden, dass sich die Kontaktlasche 10 beziehungsweise das Distanzelement 8 von der Endstellung selbsttätig wieder in die Ausgangsstellung bewegt, sobald die Kraft durch das darüber angeordnete Photovoltaikmodul P2, P3 nicht weiter anhält bzw. wegfällt.

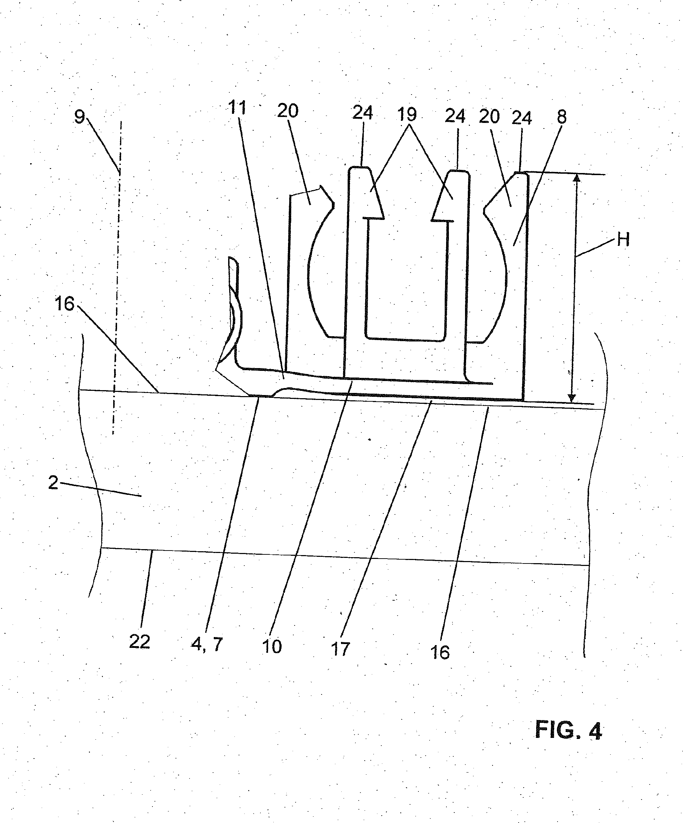

In der Figur 4 wird die Kontaktlasche 10 und das Distanzelement 8 im Detail gezeigt. Hier kann gut erkannt werden, dass zwischen dem Distanzelement 10 und der Seitenwandung 3 eine Querschnittsverjüngung 11 angeordnet ist, wobei diese Querschnittsverjüngung 11 im Wesentlichen die Federeigenschaften der Kontaktlasche 10 beeinflussen.

Die Querschnittsverjüngung 11 kann auch als Filmscharnier bezeichnet werden. Das Filmscharnier kann dabei so ausgebildet sein, dass nach erfolgter Installation des Photovoltaikmoduls, also dann wenn keine weiteren Photovoltaikmodule auf dem montierten Modul aufliegen sollen, das Filmscharnier von Hand oder mit einem Werkzeug weggebrochen werden kann. Dadurch kann das Distanzelement 10 irreversibel vom Anschlussdosengehäuse 1 entfernt werden, wenn es nicht mehr benötigt wird.

Weiter kann in der Figur 4 ebenfalls gut erkannt werden, dass zwischen der Oberfläche 16 der Photovoltaikpaneele 2 ein Zwischenraum 17 vorhanden ist. Dieser Zwischenraum 17 ist aber, wie bereits oben beschrieben nur-in der Ausgangsstellung vorhanden. In der Endstellung, also wenn das Distanzelement 8 mit einer entsprechenden. Gewichtskraft eines Photovoltaikmoduls belastet wird, liegt das Distanzelement 8 im Wesentlichen vollständig auf der Oberfläche 16 der Photovoltaikpaneele 2 auf. Der Zwischenraum 17 wird somit im belasteten Zustand aufgehoben.

Die Kontaktlasche 10 erstreckt sich im Wesentlichen parallel zur Bodenebene 7. Von der Kontaktlasche 10 erstreckt sich dann das Distanzelement 8 im Wesentlichen senkrecht. Mit anderen Worten kann auch gesagt werden, dass sich das Distanzelement 8 im Wesentlichen senkrecht zur Bodenebene 7 erstreckt.

Von den Figuren 1 bis 3 kann auch erkannt werden, dass das Anschlussdosengehäuse weiter zwei Aufnahmeelemente 12 für die Aufnahme von elektrisch leitenden Anschlusselementen für die elektrische Kontaktierung von Kabeln und der Diode aufweist.

Zwischen den beiden Aufnahn1eelementen 12 erstreckt sich senkrecht zur Bodenebene 7 eine Referenzebene 13. In dieser bevorzugten Ausführungsform sind zwei Distanzelemente 8 angeordnet, welche symmetrisch bezüglich der Referenzebene 13 angeordnet sind. Dadurch kann eine besonders gute Kraftübertragung über die Distanzelemente 8 bereit gestellt werden. Mit anderen Worten kann auch gesagt werden, dass die Distanzelemente 8 seitlich vom Anschlussdosengehäuse 1 abstehen. Die Aufnahmeelemente 12 sind in der vorliegenden Ausführungsform winklig zueinander angeordnet, was Vorteile bezüglich der Kabelführung bei der Verbindung von zwei benachbarten Photovoltaikmodulen aufweist.

Das Distanzelement 8 kann in einer vielfältigen Art und Weise ausgebildet sein. Wichtig ist, dass das Distanzelement 8 die einwirkenden Kräfte aufnehmen und übertragen kann, und dass es nicht zu einem Bruch des Distanzelementes 8 kommt. Es ist beispielsweise denkbar, dass sich das Distanzelement 8 als Zylinder oder als Hohlzylinder von der Kontaktlasche absteht, wobei der Zylinder bzw. der Holzylinder einen beliebigen Querschnitt aufweisen kann. Beispielsweise ein kreisrunder, ein quadratischer, ein rechteckiger, ein elliptischer oder eine polygonaler Querschnitt.

Weiter kann das Distanzelement 8 noch weitere Funktionen haben, wie beispielsweise in der vorliegenden Ausführungsform gezeigt. Das Distanzelement 8 weist in der vorliegenden Ausführungsform die Gestalt eines Klemmelementes 18 zur mechanischen Klemmung eines Kabels und/oder eines Steckers auf. Folglich hat das Distanzelement 8 hier zwei unterschiedliche Funktionen. Einerseits dient es als Klemmelement für Kabel und Stecker während des Transportes eines Solarmoduls, andererseits dient es als Distanzelement 8 gemäss den oben beschriebenen Eigenschaften. Das Klemmelement 18 ist vorzugsweise als Schnappelement ausgebildet, wobei der Benutzer dann ein Kabel lösbar mit dem Klemmelement 18 verbinden kann. In der vorliegenden Ausführungsform weist das Klemmelement 18 zwei Klemmabschnitte 19, 20 auf, welche hintereinander angeordnet sind. Beide Klemmabschnitte 19, 20 stellen hier somit das Klemmelement 14. bereit. Es kann auch gesagt werden, dass das Distanzelement 8 hier im Wesentlichen die Gestallt des Klemmelementes 18 aufweist. Folglich wird durch das Klemmelement 18 das ist als Element 8 bereitgestellt.

Die Stirnfläche 24 zur Kontaktierung der Unterseite 22 des darüberliegenden Photovoltaikmoduls wird hier durch die Klemmanschnitte 19, 20 bereitgestellt.

Das mindestens eine Distanzelement 8 und das Anschlussdosengehäuse 1 sind vorzugsweise einstückig ausgebildet. Folglich ist das Distanzelement 8 dem Anschlussdosengehäuse 1 angeformt. Dies ist insbesondere dann vorteilhaft, wenn das Anschlussdosengehäuse 1 durch ein Spritzgussverfahren hergestellt wird. Vorzugsweise ist das Ansehlussdosengehäuse 1 aus einem Kunststoff, wie beispielsweise einem Kunststoff aus der Gruppe der Thermoplaste, insbesondere Polyamid oder Polycarbonat.

Zusammenfassend kann gesagt werden, dass das erfindungsgemässe Anschlussdosengehäuse 1 mit den am Anschlussdosengehäuse 1 angeformten Distanzelementen 8 den Vorteil hat, dass die Kräfte beim Stapeln von Photovoltaikmodulen nicht durch die Anschlussdose bzw. über den Boden 4 und die Klebestelle 15 derselben übertragen werden. Dies führt zu einer Entlastung der Klebestelle 15 und verhindert ein seitliches Fliessen des Klebstoffes 15.

### BEZUGSZEICHENLISTE

- 1: Anschlussdosengehäuse
- 2: Photovoltaikpaneele
- 3: Seitenwandung
- 4: Boden
- 5: Deckel
- 6: Innenraum
- 7: Bodenebene
- 8: Distanzelement
- 9: Senkrechte
- 10: Kontaktlasche
- 11: Querschnittsverjüngung
- 12: Aufnahmeelement
- 13: Referenzebene
- 14: Öffnung
- 15: Klebstoff
- 16: Oberfläche
- 17: Zwischenraum
- 18: Klemmelement
- 19: Klemmabschnitt
- 20: Klemmabschnitt
- 21: Flansch
- 22: Unterseite
- 23: Zwischenraum
- 24: Stirnfläche

## Patentansprüche

1. Anschlussdosengehäuse (1) für eine Photovoltaikpaneele (2), wobei das Anschlussdosengehäuse (1) eine Seitenwandung (3), einen eine Bodenebene (7) aufspannenden Boden (4) und einen Deckel (5) umfassen, wobei Seitenwandung (3), Boden (4) und Deckel (5) einen Innenraum (6) zur Aufnahme von Funktionselementen zur Wegführung von durch die Photovoltaikpaneele (2) erzeugter elektrischer Energie begrenzen, und wobei das Anschlussdosengehäuse (1) mit dem Boden (4) auf einer Photovoltaikpaneele (2) anordbar ist, **dadurch gekennzeichnet, dass** das Anschlussdosengehäuse (1) weiterhin mit mindestens einem Distanzelemente (8) in Verbindung steht, das derart angeordnet ist, dass eine Kraft, welche von einem auf der mit dem Anschlussdosengehäuse (1) versehenen Photovoltaikpaneele (2) liegenden Photovoltaikmodul (P) bereitgestellt wird, vorzugsweise ausschliesslich über das Distanzelement (8) auf die Photovoltaikpaneele (2) mit dem Anschlussdosengehäuse (1) geleitet wird.

2. Anschlussdosengehäuse (1) nach Anspruch 1, **dadurch gekennzeichnet, dass** das Distanzelement (8) in einer Ausgangsstellung bezüglich der Senkrechten (9) zur Bodenebene (7) von der Bodenebene (7) beabstandet angeordnet ist und bei einer Krafteinwirkung, insbesondere durch das Photovoltaikmodul (P) von der Ausgangsstellung in eine Endstellung zur Bodenebene (7) bewegbar ist.

3. Anschlussdosengehäuse (1) nach einem der vorhergehenden Ansprüche, **dadurch gekennzeichnet, dass** das Distanzelement (8) bezüglich der Senkrechten (9) zur Bodenebene (7) eine Höhe (H) aufweist, welche grösser ist, als die Distanz (Z) zwischen dem Boden (4) und dem Deckel (5) bezüglich der Senkrechten (9) zur Bodenebene (7).

4. Anschlussdosengehäuse (1) nach einem der vorhergehenden Ansprüche, **dadurch gekennzeichnet, dass** das Distanzelement (8) über eine federnd ausgebildete Kontaktlasche (10) am Anschlussdosengehäuse (1) angeformt ist, wobei bei einer Krafteinwirkung auf das Distanzelement (8) die Kontaktlasche (10) federnd verformbar ist.

5. Anschlussdosengehäuse (1) nach einem der vorhergehenden Ansprüche, **dadurch gekennzeichnet, dass** die Kontaktlasche (10) im Querschnitt senkrecht zur Bodenebene (7) gesehen zwischen Seitenwandung (3) und Distanzelement (8) eine Querschnittsverjüngung (11) aufweist und/oder dass die Kontaktlasche (10) als Filmscharnier ausgebildet ist.

6. Anschlussdosengehäuse (1) nach einem der vorhergehenden Anspruche, **dadurch gekennzeichnet, dass** sich die Kontaktlasche (10) im wesentlichen parallel zur Bodenebene (7) erstreckt, und/oder dass sich das Distanzelement (8) im wesentlichen senkrecht von der Kontaktlasche (10) bzw. senkrecht zur Bodenebene (7) erstreckt.

7. Anschlussdosengehäuse (1) nach einem der vorhergehenden Ansprüche, **dadurch gekennzeichnet, dass** das Anschlussdosengehäuse (1) weiter mindestens ein, vorzugsweise zwei, Aufnahmeelemente (12) für die Aufnahme von elektrisch leitenden Anschlusselementen für die elektrische Kontaktierung aufweist, wobei bei zwei Aufnahmeelemente (12) zwischen den beiden. Aufnahmeelementen (12) senkrecht zur Bodenebene (7) eine Referenzebene (13) liegt, und wobei zwei Distanzelemente (8) symmetrisch bezüglich der Referenzebene (13) angeordnet sind.

8. Anschlussdosengehäuse (1) nach einem der vorhergehenden Ansprüche, **dadurch gekennzeichnet, dass** das Distanzelement (8) mindestens ein Klemmelement (18) zur mechanischen Klemmung eines Kabels und/oder eines Steckers aufweist, wobei das Klemmelement (18) vorzugsweise als Schnappelement ausgebildet ist.

9. Anschlüssdosengehäuse (1) nach Anspruch 8, **dadurch gekennzeichnet, dass** durch das Klemmelement (18) das Distanzelement (8) bereitstellt wird.

10. Anschlussdosengehäuse (1) nach einem der vorhergehenden Ansprüche, **dadurch gekennzeichnet, dass** das mindestens eine Distanzelement (8) und das Anschlussdosengehäuse (1) einstückig ausgebildet ist, und/oder dass der Innenraum (6) über eine Öffnung (14) im Boden (4) und/oder im Deckel (5) zugänglich ist.

11. Anschlussdosengehäuse (1) nach einem der vorhergehenden Ansprüche, **dadurch gekennzeichnet, dass** der Boden (4) als Flansch (21) ausgebildet ist, welcher im wesentlichen senkrecht von der Seitenwandung (3) bezüglich des Innenraumes (6) nach aussen und/oder nach innen absteht, wobei der Flansch (21) die Seitenwandung (3) mindestens abschnittsweise, vorzugsweise vollständig, umgibt.

12. Photovoltaikanschlussdose umfassend ein Anschlussdosengehäuse (1) nach einem der vorhergehenden Ansprüche und im Innenraum (6) des Anschlussdosengehäuses angeordnete Funktionselemente zur Wegführung von durch die Photovoltaikpaneele (2) erzeugter elektrischer Energie, wobei die Funktionselemente vorzugsweise Verbindungselemente, eine Bypass-Diode und Anschlusselemente umfassen, wobei die Verbindungselemente der elektrisch leitenden Verbindung mit der Photovoltaikpaneele und der Bypassdiode dienen und wobei die Anschlusselemente der elektrisch leitenden Verbindung der Bypassdiode und externen Elementen, wie Kabel dienen.

13. Photovoltaikmodul umfassend eine Photovoltaikpaneele und mindestens eine Anschlussdosen mit einem Anschlussdosengehäuse nach einem der vorhergehenden Ansprüche.

14. Photovoltaikmodul nach Anspruch 12, **dadurch gekennzeichnet, dass** die Anschlussdosen über eine Klebeverbindung mit der Photovoltaikpaneele in Verbindung stehen.
